# FASCICULE DE BREVET EUROPEEN

(11) **EP 3 058 273 B1**
(45) Date de publication et mention de la délivrance du brevet: **13.11.2019**
(21) Numéro de dépôt: 14786187.6
(22) Date de dépôt: 17.10.2014
(51) Int. Cl.: F21S 8/00

(54) **SYSTÈME DE CONNEXION ÉLECTRIQUE D'AU MOINS UNE SOURCE DE LUMIÈRE À UN SYSTÈME D'ALIMENTATION ÉLECTRIQUE**
SYSTEM ZUM ELEKTRISCHEN VERBINDEN VON MINDESTENS EINER LICHTQUELLE AN EIN STROMVERSORGUNGSSYSTEM
SYSTEM FOR THE ELECTRICAL CONNECTION OF AT LEAST ONE LIGHT SOURCE TO AN ELECTRICAL POWER SUPPLY SYSTEM

(30) Priorité: 18.10.2013 FR 1360174
(43) Date de publication de la demande: 24.08.2016
(73) Titulaire: Valeo Vision, 93012 Bobigny Cedex (FR)
(72) Inventeur: DUARTE, Marc, 93250 Villemomble (FR); MORNET, Eric, 93012 Bobigny Cedex (FR); YVON, Sylvain, 16170 Mareuil (FR); BLANDIN, Jonathan, 93320 Les Pavillons Sous Bois (FR)
(86) Numéro de dépôt international: PCT/EP2014/072343
(87) Numéro de publication internationale: WO 2015/055827

(56) Documents cités:
- WO-A1-2011/078217

## Description

La présente invention a pour objet un système de connexion électrique d'au moins une source de lumière à un système d'alimentation électrique.

La publication WO 2011/078217 A1 divulgue un tel système de connexion.

La présente invention s'applique typiquement, mais non exclusivement, à un système permettant de connecter électriquement au moins une diode électroluminescente (DEL ; en langue anglaise « Light Emitting Diode » ou LED) au système d'alimentation électrique d'un véhicule motorisé.

La demande de brevet FR 2 906 347 divulgue un dispositif de feu pour véhicule qui comprend un module d'éclairage, ce module comportant :
- des dispositifs de lumière comprenant chacun une unité d'émission de lumière ;
- une plaque conductrice qui comporte des cavités pour recevoir les dispositifs de lumière, cette plaque permettant de connecter, notamment au moyen de pistes électriques, les dispositifs de lumière à une source d'alimentation électrique ;
- un support dissipateur de chaleur sur lequel sont disposés les dispositifs de lumière ;
- une pièce adhésive placée entre le support dissipateur et la plaque conductrice, qui permet notamment de positionner les dispositifs de lumière dans les cavités de la plaque conductrice de manière précise.

Il s'avère que la plaque conductrice du module d'éclairage objet de la demande de brevet FR 2 906 347 doit nécessairement comprendre lesdites cavités afin de pouvoir y disposer les dispositifs de lumière. Des opérations de façonnage additionnelles doivent ainsi être réalisées afin de conférer à la plaque conductrice une forme spécifique.

De plus, afin de préserver le rendement lumineux des dispositifs de lumière, il convient de recourir à un système de dissipation thermique, tel que ledit support dissipateur de chaleur, ce qui complexifie la structure du module d'éclairage.

La présente invention a notamment pour objet de remédier à ces inconvénients en proposant un ensemble lumineux tel que défini dans la revendication 1, dont la structure simplifiée permet notamment de réduire les coûts de conception et de réalisation.

A cet effet, elle propose un système de connexion électrique d'au moins une source de lumière à un système d'alimentation électrique, la borne de connexion et le moyen de connexion étant aptes à connecter électriquement la source de lumière à la grille de connexion, en permettant de disposer la source de lumière à distance de la grille de connexion.

Ci-dessus et dans ce qui suit, une grille de connexion est une structure de pistes conductrices réalisée d'un seul tenant. Cette grille de connexion, appelée « leadframe » en anglais, peut par exemple être une tôle estampée pour former des pistes électriques, puis surmoulée à un substrat isolant et dont les parties autres que celles formant les pistes sont séparées de la tôle après surmoulage.

De cette manière, la source de lumière est connectée électriquement à la grille de connexion tout en étant déportée et éloignée par rapport à cette dernière, ce qui permet avantageusement de simplifier la structure de la grille de connexion. En effet, il n'est plus nécessaire d'aménager un emplacement spécifique dans la grille de connexion afin d'y disposer la source de lumière ou de fixer sur la grille de connexion un moyen dissipant spécifiquement la chaleur émise par la source de lumière. La disposition à distance de la source de lumière par rapport à la grille de connexion est définie comme étant une disposition de la source de lumière à une distance de la grille de connexion qui réduit significativement voire supprime l'exposition de la grille de connexion à la chaleur émise par la source de lumière, ce qui permet de se dispenser de fixer sur la grille de connexion un moyen apte à dissiper spécifiquement la chaleur de la source de lumière.

Selon l'invention, la grille de connexion comporte un premier moyen dissipateur de chaleur permettant de dissiper la chaleur générée par la grille de connexion.

Préférentiellement, le premier moyen dissipateur de chaleur est un circuit résistif.

De manière préférentielle, la grille de connexion comporte un convertisseur permettant de convertir la tension, notamment alternative, du courant délivré par le système d'alimentation électrique en une tension, notamment continue, appliquée à la borne de connexion de la grille de connexion.

La tension appliquée à la borne de connexion est de préférence adaptée à l'alimentation de la source de lumière.

La grille de connexion peut comporter un moyen de protection contre les perturbations électromagnétiques.

Le premier moyen dissipateur de chaleur est avantageusement constitué par le convertisseur. Dans ce cas, le convertisseur est apte à conserver un fonctionnement normal même en cas de dissipation de chaleur importante.

Avantageusement, la grille de connexion comporte un circuit de pilotage, qui contrôle la tension du courant appliquée à ladite borne de connexion.

Préférentiellement, la borne de connexion de la grille de connexion est une languette de connexion (en langue anglaise, un « pad ») apte à permettre la connexion à la source de lumière en appliquant la technique de la soudure de fils (en langue anglaise, « wirebonding »). Cette connexion peut être réalisée par un pontage par exemple.

Selon l'invention le moyen de connexion est un fil électriquement conducteur.

De préférence, la grille de connexion comprend une plaque à circuits imprimés sur laquelle peuvent être connectés des composants électroniques.

Cette plaque comprend une pluralité de pistes électriques permettant de transporter le courant électrique, des composants électroniques étant soudés sur ces pistes à l'aide de broches de raccordement.

Le cas échéant, l'extrémité des broches de raccordement des composants électroniques traverse des trous traversant la plaque, ce qui permet d'effectuer un contrôle visuel au moyen de dispositifs optiques de la qualité des soudures effectuées au niveau de ces extrémités.

De préférence, la grille de connexion comprend une bordure, avantageusement isolante électriquement, s'étendant perpendiculairement depuis la plaque, cette bordure comportant :
- deux parois longitudinales sensiblement parallèles ;
- deux parois transversales sensiblement parallèles, qui relient chacune les deux parois longitudinales.

La bordure et la plaque avantageusement définissent un bac étanche, ce bac étant rempli avec un produit plastique liquéfié.

L'une des parois longitudinales de la bordure peut comprendre un décrochement dans lequel est disposée la borne de connexion.

De préférence, l'une des parois transversales de la bordure comprend sur sa face externe un logement faisant saillie dont les parois s'étendent sensiblement perpendiculairement à ladite paroi transversale, la grille de connexion comportant au moins un connecteur électrique disposé dans ce logement, ce connecteur permettant de connecter la grille de connexion au système d'alimentation électrique.

La face externe est ici la face dirigée vers l'extérieur de la grille de connexion.

L'ensemble lumineux selon la revendication 1 comprend notamment:
- un système de connexion électrique d'au moins une source de lumière à un système d'alimentation électrique selon l'invention ;
- au moins une source de lumière ;
- un second moyen dissipateur de chaleur permettant de dissiper la chaleur générée par la source de lumière, ce second moyen dissipateur de chaleur étant déconnecté de la grille de connexion.

Le premier moyen dissipateur de chaleur est avantageusement apte à dissiper plus de chaleur que le second moyen dissipateur de chaleur.

Préférentiellement, la source de lumière est une diode électroluminescente (DEL ; en langue anglaise « Light Emitting Diode » ou LED), cette diode électroluminescente pouvant être mono-cœur ou multi-cœur.

Le second moyen dissipateur de chaleur est un support de la source de lumière.

Le second moyen dissipateur de chaleur est avantageusement constitué par un substrat sur lequel est montée la source de lumière. Ce support peut par exemple être métallique ou réalisé en céramique.

Selon une variante d'exécution de l'invention, le second moyen dissipateur de chaleur comprend un radiateur disposé à proximité ou au contact de la source de lumière, ce second moyen dissipateur de chaleur pouvant être associé à un caloduc relié à l'une de ses extrémités à la grille de connexion et à son autre extrémité au radiateur. L'utilisation d'un caloduc est rendue possible grâce à la disposition de la source de lumière à distance de la grille de connexion qui permet de réduire l'encombrement au niveau de la grille de connexion.

Selon une variante d'exécution de l'invention, le second moyen dissipateur de chaleur comporte un radiateur et un support métallique du type susdit.

La présente invention a également pour objet un dispositif d'éclairage et/ou de signalisation pour véhicule caractérisé en ce qu'il comporte un ensemble lumineux selon l'invention.

D'autres caractéristiques et avantages de la présente invention apparaîtront à la lumière des exemples qui vont suivre et des figures ci-annexées, lesdits exemples et figures étant donnés à titre illustratif et nullement limitatif.

La figure 1 est une représentation schématique, en perspective, de la grille de connexion du système selon l'invention.

La figure 2 est une représentation schématique, en perspective, de la grille de connexion du système selon l'invention à laquelle est connectée une source de lumière.

Pour des raisons de clarté, seuls les éléments essentiels pour la compréhension de l'invention ont été représentés de manière schématique, et ceci sans respect de l'échelle.

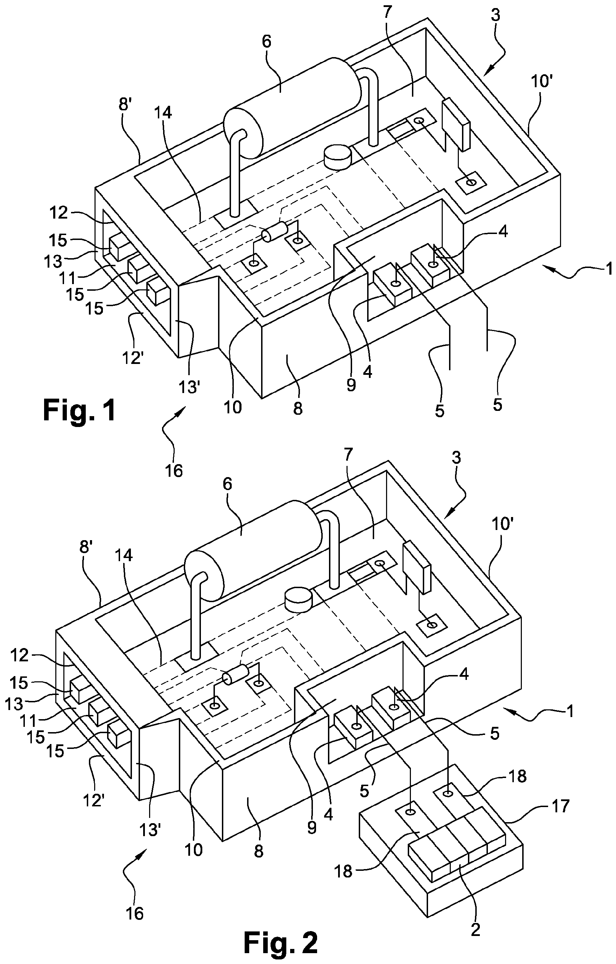

Tel qu'il est représenté sur la figure 1, le système 1 de connexion électrique selon l'invention comporte une grille de connexion 3 apte à être connectée électriquement à un système d'alimentation électrique (non représenté) tel que le circuit électrique d'un véhicule.

La grille de connexion 3 présente sensiblement la forme d'un bac comprenant :
- une plaque 7 à circuits imprimés sur laquelle peuvent être connectés des composants électroniques ;
- une bordure comportant :
   ∘ deux parois longitudinales 8, 8' sensiblement parallèles, l'une de ces parois longitudinales 8 comprenant un décrochement 9 ;
   ∘ deux parois transversales 10, 10' sensiblement parallèles, qui relient chacune les deux parois longitudinales 8, 8', l'une de ces parois transversales 10 comprenant sur sa face externe un logement 11 faisant saillie dont les parois s'étendent sensiblement perpendiculairement à ladite paroi transversale 10, ce logement 11 comportant :
      ▪ deux parois longitudinales 12, 12' sensiblement parallèles ;
      ▪ deux parois transversales 13, 13' sensiblement parallèles reliant chacune les parois longitudinales 12, 12'.

La plaque 7 est par exemple un PCB (« Printed Circuit Board ») qui comporte au moins une couche conductrice surmoulée avec un matériau isolant électriquement, par exemple une résine époxy ou de la fibre de verre.

Cette plaque 7 comprend des pistes électriques 14 permettant de transporter le courant électrique, ces pistes électriques 14 étant réalisées en soumettant la couche conductrice de la plaque 7 à un procédé d'estampage.

La grille de connexion 3 comporte des composants électroniques qui sont généralement connectés à ladite plaque 7 par soudure laser, ces composants électroniques s'étendant, selon l'orientation de la figure 1, au-dessus de la plaque 7.

L'extrémité des broches de raccordement des composants électroniques traverse la plaque 7, ce qui permet d'effectuer un contrôle visuel au moyen de dispositifs optiques de la qualité des soudures effectuées au niveau de ces extrémités.

La grille de connexion 3 comporte au moins un connecteur électrique 15 disposé dans le logement 11, ce connecteur 15 étant relié à au moins l'une des pistes électriques 14. Le connecteur 15 permet de connecter la grille de connexion 3 au système d'alimentation électrique 1. Le connecteur électrique 15 peut être, par exemple, une languette de connexion apte à permettre la connexion au système d'alimentation électrique en appliquant la technique de la soudure de fils.

La grille de connexion 3 comprend également au moins une borne de connexion 4 disposée dans le décrochement 9, cette borne de connexion 4 étant apte en coopération avec un moyen de connexion 5, à connecter électriquement une source de lumière 2 à la grille de connexion 3.

La borne de connexion 4 est une languette de connexion apte à permettre la connexion de la source de lumière 2 en appliquant la technique de la soudure de fils, le moyen de connexion 5 étant un fil électriquement conducteur.

De plus, la grille de connexion 3 comporte un premier moyen dissipateur de chaleur 6 permettant de dissiper la chaleur générée par la grille de connexion 3, ce premier moyen dissipateur de chaleur 6 consistant en un circuit résistif.

En outre, la grille de connexion 3 comprend :
- un moyen permettant de transformer la tension alternative du courant délivré par le système d'alimentation électrique en une tension continue appliquée à la borne de connexion 4 de la grille de connexion 3 ; et
- un circuit de commutation qui contrôle la tension du courant appliquée à ladite borne de connexion 4, le circuit de commutation pouvant par exemple assurer que cette tension soit comprise dans un intervalle défini.

De cette façon, la grille de connexion 3 permet de transformer et d'adapter la tension du courant délivré par le système d'alimentation électrique afin d'appliquer à la borne de connexion 4 une tension appropriée.

Selon une variante d'exécution de l'invention, l'espace délimité par la bordure de la grille de connexion 3 peut être rempli avec un produit plastique liquéfié (selon, en langue anglaise, « a potting process »).

Tel que cela est représenté sur la figure 2, un ensemble 16 d'éclairage selon l'invention comprend :
- un système 1 de connexion électrique d'au moins une source de lumière 2 à un système d'alimentation électrique comme précédemment décrit ;
- au moins une source de lumière 2 ;
- un second moyen dissipateur de chaleur 17 permettant de dissiper la chaleur générée par la source de lumière 2, ce second moyen dissipateur de chaleur 17 étant déconnecté de la grille de connexion 3.

Ainsi, chaque moyen de connexion 5 connecte une borne de connexion 4 à une languette conductrice 18 qui est reliée à au moins une source de lumière 2.

La source de lumière 2 et lesdites languettes conductrices 18 sont disposées sur le second moyen dissipateur de chaleur 17 consistant en l'espèce en un support métallique.

La source de lumière 2 est une diode électroluminescente dont la partie émissive est composée d'une puce semi-conductrice ou de plusieurs puces semi-conductrices, dans le premier cas la diode est dite mono-puce (en langue anglaise « mono-chip ») et dans le second cas la diode est dite multi-puce (en langue anglaise « multi-chip »).

Le déport de la source de lumière 2 par rapport à la grille de connexion 3 permet de simplifier la structure de la grille de connexion 3 qui ne nécessite plus de moyen dissipant spécifiquement la chaleur émise par la source de lumière 2.

## Revendications

1. Ensemble (16) lumineux, comprenant
• un système de connexion électrique (1) d'au moins une source de lumière (2) à un système d'alimentation électrique;
• au moins une source de lumière (2) ;
**caractérisé en ce que** ledit système de connexion (1) comprend :
- une grille de connexion (3) apte à être connectée électriquement à un système d'alimentation électrique, la grille de connexion (3) comportant au moins une borne de connexion (4) ;
- au moins un moyen de connexion (5) permettant de connecter électriquement la borne de connexion (4) de la grille de connexion (3) à la source de lumière (2) ;
la borne de connexion (4) et le moyen de connexion (5) étant aptes à connecter électriquement par pontage la source de lumière (2) à la grille de connexion (3), en permettant de disposer la source de lumière (2) à distance de la grille de connexion (3), le moyen de connexion (5) étant un fil électriquement conducteur,
la grille de connexion (3) comportant un premier moyen dissipateur de chaleur permettant de dissiper la chaleur générée par la grille de connexion;
et **en ce que** l'ensemble (16) lumineux comprend un second moyen dissipateur de chaleur (17) permettant de dissiper la chaleur générée par la source de lumière (2), ce second moyen dissipateur de chaleur (17) étant déconnecté de la grille de connexion (3), le second moyen dissipateur de chaleur (17) étant un support de la source de lumière.

2. Ensemble (16) lumineux selon la revendication 1, **caractérisé en ce que** le premier moyen dissipateur de chaleur (6) est un circuit résistif.

3. Ensemble (16) lumineux selon l'une des revendications 1 à 2, **caractérisé en ce que** la grille de connexion (3) comporte un convertisseur permettant de convertir la tension, notamment alternative, du courant délivré par le système d'alimentation électrique en une tension, notamment continue, appliquée à la borne de connexion (4) de la grille de connexion (3).

4. Ensemble (16) lumineux selon l'une des revendications 1 à 3, **caractérisé en ce que** la grille de connexion (3) comporte un circuit de pilotage, qui contrôle la tension du courant appliquée à ladite borne de connexion (4).

5. Ensemble (16) lumineux selon l'une des revendications précédentes, **caractérisé en ce que** la borne de connexion (4) de la grille de connexion (3) est une languette de connexion apte à permettre la connexion à la source de lumière (2) en appliquant la technique de la soudure de fils.

6. Ensemble (16) lumineux selon l'une des revendications précédentes, **caractérisé en ce que** la grille de connexion (3) comprend une plaque (7) à circuits imprimés sur laquelle peuvent être connectés des composants électroniques.

7. Ensemble (16) lumineux selon la revendication précédente, **caractérisé en ce que** la grille de connexion comprend une bordure s'étendant perpendiculairement depuis la plaque (7), cette bordure comportant :
• deux parois longitudinales (8, 8') sensiblement parallèles ;
• deux parois transversales (10, 10') sensiblement parallèles, qui relient chacune les deux parois longitudinales (8, 8').

8. Ensemble (16) lumineux selon la revendication précédente, **caractérisé en ce que** la bordure et la plaque (7) définissent un bac étanche, ce bac étant rempli avec un produit plastique liquéfié.

9. Ensemble (16) lumineux selon l'une des revendications 7 ou 8, **caractérisé en ce que** l'une des parois longitudinales (8) de la bordure comprend un décrochement (9) dans lequel est disposé la borne de connexion (4).

10. Ensemble (16) lumineux selon l'une des revendications 7 à 9, **caractérisé en ce que** l'une des parois transversales (10) de la bordure comprend sur sa face externe un logement (11) faisant saillie dont les parois s'étendent sensiblement perpendiculairement à ladite paroi transversale (10), la grille de connexion (3) comportant au moins un connecteur électrique (15) disposé dans ce logement (11), ce connecteur (15) permettant de connecter la grille de connexion (3) au système d'alimentation électrique (1).

11. Ensemble (16) lumineux selon la revendication 10, **caractérisé en ce que** la source de lumière (2) est une diode électroluminescente.

12. Dispositif d'éclairage et/ou de signalisation pour un véhicule automobile,
**caractérisé en ce qu'**il comporte un ensemble lumineux (16) selon l'une des revendications précédentes.

## Patentansprüche

1. Lichtanordnung (16), umfassend
- ein elektrisches Verbindungssystem (1) zum Verbinden mindestens einer Lichtquelle (2) mit einem Stromversorgungssystem;
- mindestens eine Lichtquelle (2);
**dadurch gekennzeichnet, dass** das Verbindungssystem (1) umfasst:
- einen Leiterrahmen (3), der elektrisch mit einem Stromversorgungssystem verbunden werden kann, wobei der Leiterrahmen (3) mindestens einen Leiteranschluss (4) umfasst;
- mindestens ein Verbindungsmittel (5) zum elektrischen Verbinden der Anschlussklemme (4) des Leiterrahmens (3) mit der Lichtquelle (2);
die Anschlussklemme (4) und das Verbindungsmittel (5) in der Lage sind, die Lichtquelle (2) durch Brücken mit dem Anschlussnetz (3) elektrisch zu verbinden, so dass die Lichtquelle (2) entfernt vom Anschlussnetz (3) angeordnet werden kann, wobei das Verbindungsmittel (5) ein elektrisch leitfähiger Draht ist,
wobei der Leadframe (3) eine erste Kühlkörperanordnung zum Ableiten der durch den Leadframe erzeugten Wärme aufweist; und dass die Lichtanordnung (16) eine zweite Kühlkörperanordnung (17) zum Ableiten der durch die Lichtquelle (2) erzeugten Wärme aufweist, wobei die zweite Kühlkörperanordnung (17) vom Leadframe (3) getrennt ist, wobei die zweite Kühlkörperanordnung (17) ein Träger der Lichtquelle ist.

2. Leuchtenanordnung (16) nach Anspruch 1, **dadurch gekennzeichnet, dass** die erste Kühlkörperanordnung (6) eine Widerstandsschaltung ist.

3. Leuchtende Anordnung (16) nach einem der Ansprüche 1 bis 2, **dadurch gekennzeichnet, dass** der Leiterrahmen (3) einen Wandler zum Umwandeln der Spannung, insbesondere Wechselspannung, des vom Stromversorgungssystem gelieferten Stroms in eine Spannung, insbesondere Gleichspannung, die an den Leiteranschluss (4) des Leiterrahmens (3) angelegt wird, beinhaltet.

4. Leichte Anordnung (16) nach einem der Ansprüche 1 bis 3, **dadurch gekennzeichnet, dass** der Leiterrahmen (3) eine Steuerschaltung beinhaltet, die die an den Leiterrahmen (4) angelegte Stromspannung steuert.

5. Leuchtende Anordnung (16) nach einem der vorhergehenden Ansprüche, **dadurch gekennzeichnet, dass** die Anschlussklemme (4) des Anschlussgitters (3) eine Anschlusslasche ist, die durch Anwendung der Drahtschweißtechnik eine Verbindung mit der Lichtquelle (2) ermöglichen kann.

6. Leuchtende Anordnung (16) nach einem der vorstehenden Ansprüche, **dadurch gekennzeichnet, dass** der Leiterrahmen (3) eine Leiterplatte (7) umfasst, auf der elektronische Komponenten verbindbar sind.

7. Leichte Anordnung (16) nach dem vorhergehenden Anspruch, **dadurch gekennzeichnet, dass** der Leiterrahmen einen Rand umfasst, der sich senkrecht von der Platte (7) erstreckt, wobei der Rand Folgendes umfasst
- zwei im Wesentlichen parallele Längswände (8, 8');
- zwei im Wesentlichen parallele Querwände (10, 10'), die jeweils die beiden Längswände (8, 8') verbinden.

8. Leichte Anordnung (16) nach dem vorhergehenden Anspruch, **dadurch gekennzeichnet, dass** der Rand und die Platte (7) einen wasserdichten Behälter definieren, der mit einem verflüssigten Kunststoffprodukt gefüllt ist.

9. Leichte Baugruppe (16) nach einem der Ansprüche 7 oder 8, **dadurch gekennzeichnet, dass** eine der Längswände (8) der Kante eine Aussparung (9) aufweist, in der der Anschlussklemme (4) angeordnet ist.

10. Leichte Baugruppe (16) nach einem der Ansprüche 7 bis 9, **dadurch gekennzeichnet, dass** eine der Querwände (10) der Kante auf ihrer Außenseite ein Gehäuse (11) umfasst, das von seiner Außenseite vorsteht, dessen Wände sich im Wesentlichen senkrecht zu der Querwand (10) erstrecken, wobei der Leiterrahmen (3) mindestens einen elektrischen Verbinder (15) aufweist, der in dem Gehäuse (11) angeordnet ist, wobei der Verbinder (15) es ermöglicht, den Leiterrahmen (3) mit dem Stromversorgungssystem (1) zu verbinden.

11. Die Anordnung (16) nach Anspruch 10, **dadurch gekennzeichnet, dass** die Lichtquelle (2) eine lichtemittierende Diode ist.

12. Beleuchtungs- und/oder Signalvorrichtung für ein Kraftfahrzeug, **dadurch gekennzeichnet, dass** sie eine Leuchtenanordnung (16) nach einem der vorstehenden Ansprüche umfasst.

## Claims

1. Luminous assembly (16), comprising
- an electrical connection system (1) for connecting at least one light source (2) to a power supply system;
- at least one light source (2);
**characterized in that** said connection system (1) comprises:
- a connection grid (3) capable of being electrically connected to a power supply system, the connection grid (3) comprising at least one connection terminal (4);
- at least one connection means (5) for electrically connecting the connection terminal (4) of the connection grid (3) to the light source (2);
the connection terminal (4) and the connection means (5) being capable of electrically connecting the light source (2) to the connection grid (3) by bridging, allowing the light source (2) to be arranged remotely from the connection grid (3), the connection means (5) being an electrically conductive wire,
the connection grid (3) having a first heat sink means for dissipating the heat generated by the connection grid;
and **in that** the luminous assembly (16) comprises a second heat sink means (17) for dissipating the heat generated by the light source (2), said second heat sink means (17) being disconnected from the connection grid (3), the second heat sink means (17) being a support of the light source.

2. Luminous assembly (16) according to claim 2, **characterized in that** the first heat sink means (6) is a resistive circuit.

3. Luminous assembly (16) according to one of claims 1 to 2, **characterized in that** the connection grid (3) includes a converter for converting the voltage, in particular alternating voltage, of the current supplied by the power supply system into a voltage, in particular continuous voltage, applied to the connection terminal (4) of the connection grid (3).

4. Luminous assembly (16) according to one of claims 1 to 3, **characterized in that** the connection grid (3) includes a control circuit, which controls the current voltage applied to said connection terminal (4).

5. Luminous assembly (16) according to one of the previous claims, **characterized in that** the connection terminal (4) of the connection grid (3) is a connection tab capable of allowing connection to the light source (2) by applying the wire welding technique.

6. Luminous assembly (16) according to one of the preceding claims, **characterized in that** the connection grid (3) comprises a printed circuit board (7) on which electronic components can be connected.

7. Luminous assembly (16) according to the preceding claim, **characterized in that** the connection grid comprises a border extending perpendicularly from the board (7), said border comprising :
- two substantially parallel longitudinal walls (8, 8');
- two substantially parallel transverse walls (10, 10'), which each connect the two longitudinal walls (8, 8').

8. Luminous assembly (16) according to the previous claim, **characterized in that** the edge and the board (7) define a waterproof container, which container is filled with a liquefied plastic product.

9. Luminous assembly (16) according to one of claims 7 or 8, **characterized in that** one of the longitudinal walls (8) of the edge comprises a recess (9) in which the connection terminal (4) is arranged.

10. Luminous assembly (16) according to one of claims 7 to 9, **characterized in that** one of the transverse walls (10) of the border comprises on its outer side a housing (11) projecting from its outer side whose walls extend substantially perpendicular to said transverse wall (10), the connection grid (3) having at least one electrical connector (15) disposed in said housing (11), said connector (15) allowing the connection grid (3) to be connected to the power supply system (1).

11. Luminous assembly (16) according to claim 10, **characterized in that** the light source (2) is a light-emitting diode.

12. Lighting and/or signalling device for a motor vehicle, **characterized in that** it comprises a luminous assembly (16) according to one of the preceding claims
